# EUROPÄISCHE PATENTSCHRIFT

(11) **EP 0 612 292 B1**
(45) Veröffentlichungstag und Bekanntmachung des Hinweises auf die Patenterteilung: **11.06.1997**
(21) Anmeldenummer: 92923733.7
(22) Anmeldetag: 17.11.1992
(51) Int. Cl.: B60R 16/00

(54) **LENKRAD FÜR KRAFTFAHRZEUGE**
VEHICLE STEERING WHEEL
VOLANT POUR VEHICULES AUTOMOBILES

(30) Priorität: 19.11.1991 DE 4137975
(43) Veröffentlichungstag der Anmeldung: 31.08.1994
(73) Patentinhaber: MST Automotive GmbH Automobil-Sicherheitstechnik, 63743 Aschaffenburg (DE)
(72) Erfinder: BOSSLER, Hans-Jürgen, D-6115 Münster (DE); KREUZER, Martin, D-8751 Kleinwallstadt (DE)
(74) Vertreter: Fuchs, Luderschmidt & Partner Patentanwälte
(86) Internationale Anmeldenummer: EP9202642
(87) Internationale Veröffentlichungsnummer: WO9309976

(56) Entgegenhaltungen:
- EP-A- 0 171 738
- DE-A- 1 948 615
- DE-A- 3 236 257
- DE-A- 3 506 332
- US-A- 4 228 115
- US-A- 4 453 088
- US-A- 4 575 117
- ELECTRO CONFERENCE RECORD, Band 16, 16-18. April 1991, New York, US, Seiten 666-668, XP000288444, Yaninger, Stuart I., Dr: "Force Sensing Resistors (Trade Mark): A review of the technology"

## Beschreibung

Die Erfindung betrifft ein Lenkrad für Kraftfahrzeuge, bei dem Lenkradkranz, Lenkradspeichen und der im Lenkrad im Bereich über der Lenkradnabe angeordnete Aufprallschutz mit einer Schicht aus Polyurethan-Schaum mit verdichteter Haut (Integralhaut) oder thermoplastischem Kunststoff, wie PVC oder PP, überzogen sind und im fahrgastzellenseitigen Teil der Schicht im Bereich der Speichen und/oder des Aufprallschutzes wenigstens ein mit dem elektromechanischen Drehübertrager verbundener Tastschalter integriert ist.

Aussehen und Bedienungsgefühl eines derartig gestalteten Lenkrads sollen nicht nur die Eigenart des Fahrzeugtyps zur Geltung bringen, sie müssen auch immer dem Komfortwunsch des Fahrzeuglenkers entsprechen und häufig auch seinem Prestigebedürfnis dienen. Eine besondere Steigerung des Komforts wird durch das Einbeziehen verschiedener Bedienungsfunktionen in das Lenkrad erreicht. Durch in die Schicht aus Polyurethan-Schaum oder in die Kunststoffschicht eingefügte und deutlich sichtbare Tastschalter werden jedoch in nachteiliger Weise die ästhetische Wirkung und das Bedienungsgefühl des Lenkrads erheblich beeinträchtigt.

Zur Verbesserung der ästhetischen Wirkung ist bei dem in der DE-B-1 948 615 beschriebenen, mit einem als Aufprallschutz dienenden Deformationskörper versehenen Lenkrad vorgesehen, daß auf der der Fahrgastzelle abgekehrten Seite des Deformationskörpers einer der beiden Kontakte und am Lenkrad selbst der andere Kontakt des Schalters für die Signalanlagen sowie zwei Federn angebracht sind, von denen eine einer Annäherung, die andere einer Entfernung des Deformationskörpers an das bzw. vom Lenkrad weg entgegenwirkt, wodurch der Deformationskörper federnd im Kontaktabstand gehalten ist. Der Deformationskörper wird somit als Kontaktgeber für die elektrische Kontakteinrichtung und gleichzeitig zum Verdecken ihrer Bauteile benutzt.

Aus der den Merkmalen des Oberbegriffs entsprechenden DE-A-3 236 257 ist bekannt, bei einem mit einer Polyurethan-Schaumschicht ummantelten Lenkrad einen plattenförmig gestalteten, aus einer in die Polyurethan-Schaumschicht eingeschäumten Metall-Kunststoff-Folie bestehenden, mit der Lenkradspeiche oder Lenkradnabe zusammenwirkenden Kontaktgeber vorzusehen. Die Metallschicht ist über ein Kabel mit dem Schleifring der Kontakteinrichtung verbunden, wobei zwischen der Metallschicht der Metall-Kunststoff-Folie und dem an der Lenkradspeiche oder Lenkradnabe befindlichen Gegenkontakt eine im Kontaktbereich ausgesparte Schicht eines elastischen, den Kontaktabstand aufrechthaltenden Schaumstoffs angeordnet ist. Dabei ist jedoch nachteilig, daß durch die im Laufe der Zeit erfolgenden Betätigungen des Kontaktgebers ein nicht unbeachtlicher Verschleiß eintritt, der die Funktionssicherheit des Kontaktgebers beeinträchtigt. Darüber hinaus läßt sich der Kontaktgeber beim Einschäumen in die Polyurethan-Schaumschicht nicht sicher in der "Aus"-Position halten, da durch den beim Schäumungsprozeß auftretenden Druck bzw. durch die Temperatur diese Position verändert werden kann.

Einen ähnlichen Aufbau besitzt der in der DE-A-3 506 332 beschriebene Membranschalter mit mindestens zwei Filmelektroden für Lenkräder von Kraftfahrzeugen, wobei zwischen den Filmelektroden eine Lage aus einem bei Druckbeaufschlagung elektrisch leitend werdendem Gummi als Abstandhalter vorgesehen ist.

Aus Electro Conference Record, Band 16, 16.-18. April 1991, New York, Seiten 666-668, XP000288444, Dr. Stuart I. Yaninger, "Force sensing resistors: A review of the technology" ist zwar ein kraftsensierender Widerstand und ein daraus hergestellter Kraft- oder Stoßsensor bekannt, dessen elektrischer Widerstand mit zunehmendem Druck abnimmt und der aus halbleitenden Polymerfolien und darauf unmittelbar aufliegender Leiterbahnfolie aufgebaut ist, ein Hinweis auf eine mögliche Verwendung als Tastschalter bei einem Kraftfahrzeug-Lenkrad ist dem Dokument jedoch nicht zu entnehmen.

Es ist die Aufgabe vorliegender Erfindung, für ein Lenkrad der eingangs beschriebenen Bauweise den Tastschalter so auszubilden, daß dieser kontaktwegfrei und sicher bedienbar ist und problemlos in die Polyurethan-Schaumschicht bzw. Kunststoffschicht des Lenkrades einfügbar ist.

Die Lösung dieser Aufgabe erfolgt durch die Merkmale des Patentanspruchs.

Die Halbleiterpolymer-Folie bildet einen Isolator zwischen der am Lenkradskelett angebrachten Kontaktfläche und der Leiterbahn-Folie; sie leitet nur, wenn von außen, z.B. mittels der Finger, der Tastschalter mit einem Druck beaufschlagt wird. Je höher der ausgeübte Druck ist, um so höher wird die Leitfähigkeit der Halbleiterpolymer-Folie. Diese Wirkung ist auf die in Tastschaltern auftretenden Kräfte abgestimmt und in diesen Grenzen reproduzierbar. Die durch den Tastschalter fließenden Ströme liegen in der Regel im Mikroampärebereich. Je nach Druckbelastung verringert sich der innere Widerstand des Tastschalters von > 5 MΩ bis zu 1 kΩ.

Da die aktiven Kontakt- bzw. Schaltflächen des Tastschalters ständig direkt aufeinander liegen, sind keine Abstandshalter erforderlich und es lassen sich Tastschalterflächen beliebiger Geometrie ohne Aussetzer in den Kontaktflächen verwenden. Die Tastschalter besitzen eine vergleichsweise große Lebensdauer, da keine beweglichen Teile vorliegen. Darüber hinaus haben die Tastschalter eine Reaktionszeit von 1 bis 2 ms und sind deshalb gegen laute Geräusche, Tonschwingungen oder Oberwellenfrequenzen unempfindlich.

Der Tastschalter ist mit einem elektronischen Komparator verbunden, der die durch die beim Einfügen des Tastschalters in die Polyurethan-Schaumschicht oder Kunststoffschicht infolge der Einwirkung der bei dem Beschichtungsvorgang auftretenden Drücke und der Temperaturen eintretende Änderung des Widerstandswertes des Tastschalters eliminiert.

Die Erfindung ist nachfolgend anhand einer Zeichnung näher und beispielhaft erläutert.

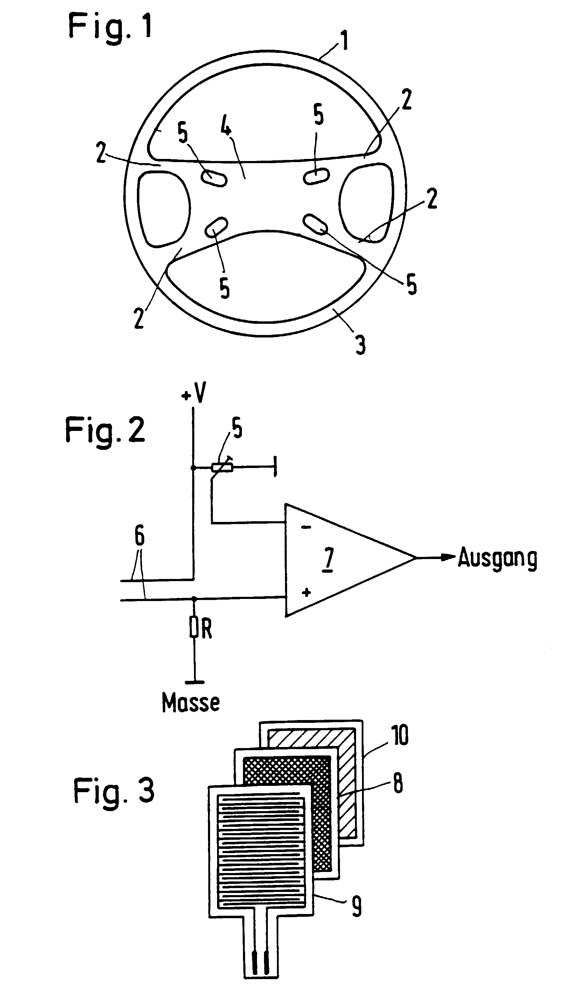

Bei dem in Fig. 1 in Draufsicht dargestellten Lenkrad (1) sind die vier Lenkradspeichen (2), der Lenkradkranz (3) und der im Bereich über der Lenkradnabe angebrachte Aufprallschutz (4), der fest mit dem Lenkrad (1) verbunden ist, mit einer Schicht aus Polyurethan-Schaum mit Integralhaut überzogen. Die Signalgebung erfolgt über vier separate Tastschalter (5), die in die Polyurethan-Schaumschicht des Aufprallschutzes (4) eingeschäumt sind.

Gemäß Fig. 2 sind die Tastschalter (5) über einen Stromkreis (6) des nicht dargestellten Kraftfahrzeugs mit + V und über einen Widerstand R mit Masse verbunden. Der Strom fließt über einen Komparator (7) zur nicht dargestellten Signalanlage.

Der in Fig. 3 in seinem Grundaufbau dargestellte Tastschalter besteht aus der Halbleiterpolymer-Folie (8), die als Isolator zwischen der unmittelbar darauf aufliegenden fahrgastzellenseitigen Leiterbahn-Folie (9) und der unmittelbar am Lenkrad (1) angebrachten Kontaktfläche (10) dient.

## Patentansprüche

1. Lenkrad für Kraftfahrzeuge, bei dem Lenkradkranz (3), Lenkradspeichen (2) und der im Lenkrad (1) im Bereich über der Lenkradnabe angeordnete Aufprallschutz (4) mit einer Schicht aus Polyurethan-Schaum mit verdichteter Haut (Integralhaut) oder thermoplastischem Kunststoff, wie PVC oder PP, überzogen sind und im fahrgastzellenseitigen Teil der Schicht im Bereich der Speichen und/oder des Aufprallschutzes wenigstens ein mit einem elektromechanischen Drehübertrager verbundener Tastschalter (5) integriert ist, dadurch gekennzeichnet, daß der Tastschalter (5) aus einer lenkradseitigen Kontaktfläche (10), einer unmittelbar auf dieser aufliegenden Halbleiterpolymer-Folie (8) und einer auf dieser direkt aufliegenden fahrgastzellenseitigen Leiterbahn-Folie (9) besteht und mit einem elektronischen Komparator (7) verbunden ist.

## Claims

1. A steering wheel for motor vehicles, in which the rim (3), spokes (2), and the means of impact protection (4) arranged in the areas above the wheel hub, are covered by a layer of polyurethane foam with a compacted skin (integral skin) or thermoplastic material such as PVC or PP, and in which, in the passenger compartment side of the layer, in the area of the spokes and/or the means of impact protection, at least one momentary contact switch (5) is integrated, connected to an electromechanical rotary transformer, characterised in that the momentary contact switch (5) consists ofa contact surface (10) on the steering wheel side, a semi-conductor polymer film (8) located directly on this, and a conductor path film (9) located directly on this on the passenger compartment side, and is connected to an electronic comparator (7).

## Revendications

1. Volant pour véhicules automobiles, sur lequel la jante (3), les rayons (2) et la protection anti-impact (4) disposée dans le volant (1) dans la zone au-dessus du moyeu du volant sont revêtus d'une couche à base de mousse de polyuréthanne avec peau comprimée (peau intégrale) ou thermoplastique tel que PVC ou polypropylène et au moins un interrupteur-poussoir (5) relié à un transmetteur de rotation électromécanique est intégré dans la partie côté habitacle des passagers de la couche dans la zone des rayons et/ou de la protection anti-impact, caractérisé en ce que le bouton-poussoir (5) comprend une surface de contact (10) côté volant, une feuille polymère semi-conductrice (8) reposant directement sur celle-ci et une feuille à piste conductive (9) côté habitacle des passagers reposant directement sur celle-ci et est relié à un comparateur (7) électronique.
